Europäisches Patentamt

European Patent Office

Office européen des brevets

(11) Veröffentlichungsnummer: **0 396 804**

**A1**

## (12) EUROPÄISCHE PATENTANMELDUNG

(21) Anmeldenummer: **89108517.7**

(22) Anmeldetag: **11.05.89**

(51) Int. Cl.⁵: **G01R 33/36**

(43) Veröffentlichungstag der Anmeldung:
**14.11.90 Patentblatt 90/46**

(84) Benannte Vertragsstaaten:
**DE FR GB**

(71) Anmelder: **Siemens Aktiengesellschaft**
**Wittelsbacherplatz 2**
**D-8000 München 2(DE)**

(72) Erfinder: **Erhard, Peter**
**Alterlanger Strasse 33**
**D-8520 Erlangen(DE)**
Erfinder: **Requardt, Hermann, Dr.phil.nat.**
**Hofmannstrasse 107**
**D-8520 Erlangen(DE)**

(54) **Oberflächenspule für ein Kernspin-Resonanzgerät.**

(57) Die erfindungsgemäße Oberflächenspule besteht aus einer Leiteranordnung, die zu verschiedenen aktiven Spulensegmenten (I-IV) in Form von Empfangsschleifen unterschiedlicher Größe und/oder Lage zusammengeschaltet werden kann. Dabei ist jedes Ende jeder möglichen Empfangsschleife (I-IV) über eine erste steuerbare Kapazität (50,52,54,56,58,60,62) mit einer Signal-Bezugsleitung (78) und über eine zweite steuerbare Kapazität (51,53,55, 57,59,61,63) mit einer an eine Auswerteeinheit (21) angeschlossenen Signalleitung (79) verbunden. Mit dieser Anordnung ist es möglich, einzelne Spulensegmente zu aktivieren, diese auf Resonanz abzugleichen und eine Impedanz der Zuleitung bzw. der Auswerteeinheit anzupassen.

FIG 4

## Oberflächenspule für ein Kernspin-Resonanzgerät

Die Erfindung betrifft eine Oberflächenspule für ein Kernspin-Resonanzgerät zur Ermittlung von Spektren oder Bildern eines Untersuchungsobjektes, bestehend aus einer Leiteranordnung, die zu verschiedenen aktiven Spulensegmenten in Form von Empfangsschleifen unterschiedlicher Größe und/oder Lage zusammengeschaltet werden kann.

Eine derartige Oberflächenspule ist aus der EP-AI-0 280 908 bekannt. Dabei kann die wirksame Fläche der Oberflächenspule durch entsprechende Stellung von Schaltern an die jeweiligen Erfordernisse angepaßt werden. Beispielsweise kann zwischen einem großen Meßfeld mit hoher Eindringtiefe, jedoch geringer Auflösung, und einem kleinen Meßfeld mit geringer Eindringtiefe, jedoch hoher Auflösung, gewählt werden. Ferner können z.B. zur Untersuchung der Wirbelsäule die aktiven Spulensegmente entlang der Wirbelsäule fortgeschaltet werden, so daß ohne mechanische Bewegung des Patienten oder der Oberflächenspule eine vollständige Untersuchung der Oberflächenspule mit hoher Auflösung möglich wird.

Aufgabe der Erfindung ist es, die eingangs genannte Anordnung so auszugestalten, daß eine einfache Abstimmung und Anpassung der Oberflächenspule möglich wird. Diese Aufgabe wird erfindungsgemäß gelöst durch die kennzeichnenden Merkmale des Anspruchs 1. Damit ist es mit geringem Aufwand möglich, einzelne Spulensegmente zu aktivieren, diese auf Resonanz abzugleichen und an die Impedanz der Zuleitung bzw. der Auswerteeinheit anzupassen. Zum Anschluß an die Auswerteeinheit sind nur zwei Leitungen in der Art von Bus-Leitungen erforderlich. Nicht aktivierte Spulensegmente werden verstimmt.

Vorteilhafte Ausgestaltungen der Erfindung sind in den Unteransprüchen angegeben.

Ausführungsbeispiele der Erfindung werden nachfolgend anhand der Fig. 1 bis 4 näher erläutert.

Fig. 1 zeigt schematisch den Aufbau eines Kernspin-Resonanzgerätes,

Fig. 2 zeigt schematisch den Aufbau einer Oberflächenspule nach dem Stand der Technik,

Fig. 3 zeigt die für eine einzelne Empfangsschleife erforderliche Beschaltung,

Fig. 4 zeigt ein Ausführungsbeispiel der erfindungsgemäßen Oberflächenspule.

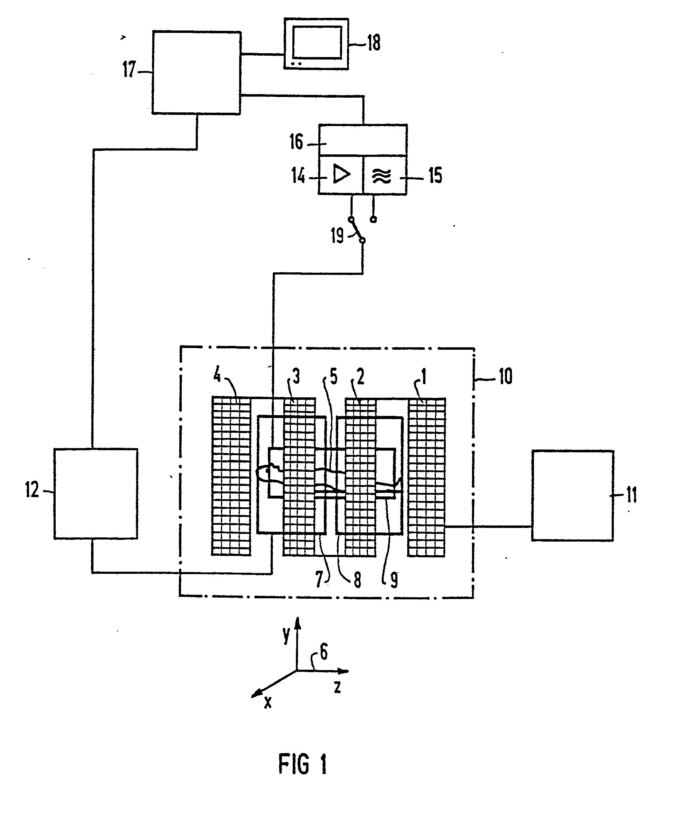

Bei dem in Fig. 1 dargestellten prinzipiellen Aufbau eines Kernspin-Resonanzgerätes zur Ermittlung von Bildern oder Spektren eines Untersuchungsobjektes sind mit 1 und 2 sowie 3 und 4 Spulen bezeichnet, die ein magnetisches Grundfeld $B_o$ erzeugen, in welchem sich bei medizinischer Anwendung der zu untersuchende Körper 5 eines Patienten befindet. Diesem sind außerdem Gradientenspulen zugeordnet, die zur Erzeugung unabhängiger, zueinander senkrechter Magnetfeldgradienten der Richtungen x, y und z gemäß dem Koordinatenkreuz 6 vorgesehen sind. In Fig. 1 sind der Übersichtlichkeit halber nur die Gradientenspulen 7 und 8 gezeichnet, die zusammen mit einem Paar gegenüberliegender, gleichartiger Gradientenspulen zur Erzeugung eines Gradienten in x-Richtung dienen. Die gleichartigen, nicht gezeichneten Gradientenspulen zur Erzeugung eines Gradienten in y-Richtung liegen parallel zum Körper 5 und oberhalb sowie unterhalb von ihm, die Gradientenspulen für das Gradientenfeld in z-Richtung liegen quer zu seiner Längsachse am Fuß- und am Kopfende. Die Anordnung enthält außerdem noch einen zur Erzeugung der Kernresonanzsignale dienenden Körper-Resonator 9 als Antenne. Zur Aufnahme der Kernresonanzsignale ist eine Oberflächenspule 19 vorgesehen, die alternativ zum Körper-Resonator 9 auch zur Erzeugung der Kernresonanzsignale dienen kann.

Das eigentliche Untersuchungsinstrument besteht aus den von einer strichpunktierten Linie 10 umgrenzten Spulen 1, 2, 3, 4, 7 und 8 sowie dem Körper-Resonator 9 und der Oberflächenspule 19. Zum Betrieb der Spulen 1 bis 4 ist ein Netzgerät 11 vorgesehen. An einer Gradientensstromversorgung 12 liegen die Gradientenspulen 7 und 8 sowie weitere, nicht dargestellte Gradientenspulen an. Ein von einem Prozeßrechner 17 gesteuerter Hochfrequenzsender 14 ist mit dem Körper-Resonator 9 verbunden. Die Oberflächenspule 19 ist über einen Signalverstärker 15 ebenfalls an den Prozeßrechner 17 gekoppelt, an dem zur Ausgabe eines Bildes ein Bildschirmgerät 18 angeschlossen ist. Die Komponenten 14 und 15 bilden eine Hochfrequenzeinrichtung 16 zur Signalerzeugung und -aufnahme.

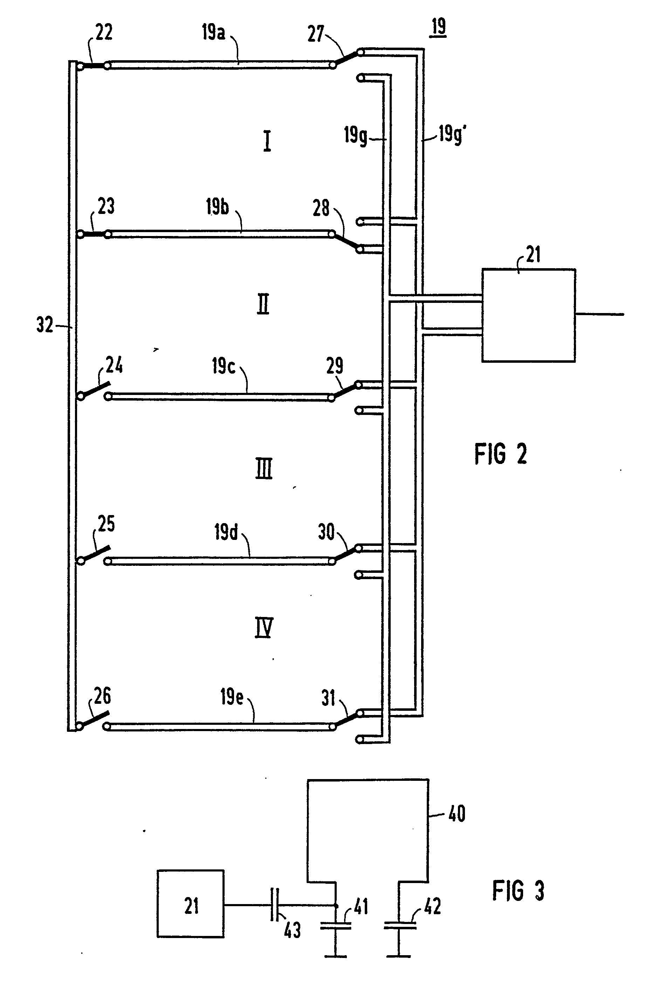

Fig. 2 zeigt zur Erläuterung der Problemstellung eine bekannte Oberflächenspule, wie sie in der oben genannten EP-AI-0 280 908 beschrieben ist. Die Oberflächenspule 19 weist dabei eine Leiterstruktur auf, wobei der linke Außenleiter 32 und die beiden rechten Außenleiter 19g und 19g′ über voneinander beabstandete, parallele Zwischenleiter 19a bis 19e und Schalter 22 bis 26 bzw. Umschalter 27 bis 31 verbunden sind. Dabei ist das linke Ende jedes Zwischenleiters 19a bis 19e über je einen Schalter 22 bis 26 mit dem linken Außenleiter 32 und das rechte Ende jedes Zwischenleiters 19a bis 19e über je einen Umschalter 27 bis 31 wahlweise mit dem Außenleiter 19g bzw. 19g′ verbindbar. Die beiden Außenleiter 19g und 19g′ sind an eine Auswerteeinheit 21 angeschlossen. Je nach Stellung der Schalter 22 bis 26 und der Umschalter 27 bis 31 kann man nun eines oder mehrere der mit I bis IV bezeichneten Segmente der Oberflächenspule 19 an die Auswertespule 21 anschließen und damit aktivieren. Bei der in Fig. 2 dargestellten Schalterstellung ist beispielsweise das Segment I der Oberflächenspule 19 aktiv. Die Lage des jeweils aktiven Segments und damit des Untersuchungsbereiches kann zwischen den Segmenten I bis IV beliebig verschoben werden, so daß z.B. unterschiedliche Bereiche der Wirbelsäule nacheinander ohne mechanische Verschiebung der Oberflächenspule untersucht werden können. Der wirksame Teil der Oberflächenspule umfaßt dabei jeweils nur eine kleine Fläche, so daß eine hohe Auflösung erzielt wird. Durch entsprechende Stellung der Schalter 22 bis 26 und der Umschalter 27 bis 31 ist es auch möglich, einen größeren Untersuchungsbereich mit einer Aufnahme zu erfassen, um beispielsweise das Problemgebiet einzugrenzen und dieses dann in einem nächsten Schritt mit einem einzelnen Segment I bis IV mit höherer Auflösung zu untersuchen.

Mit der erfindungsgemäßen Anordnung soll nun jedes aktivierbare Segment der Oberflächenspule zur Betriebsfrequenz des Kernspin-Tomographen resonant geschaltet werden können und ferner eine Anpassung an die Leitungsimpedanz der Zuleitung zur Auswerteeinheit 21 erfolgen.

Fig. 3 zeigt schematisch eine aus einem Segment der Oberflächenspule 19 gebildete Leiterschleife 40, deren beide Enden über Kondensatoren 41 und 42 an Masse gelegt sind. Die Kondensatoren 41 und 42 sind dabei so zu bestimmen, daß die Empfangsschleife 40 resonant wird. Dabei ist es vorteilhaft, wenn die beiden Kondensatoren 41 und 42 dieselbe Kapazität aufweisen, da dann die Anordnung erdsymmetrisch und damit unempfindlicher gegen Verstimmungen wird.

Das mit der Empfangsschleife 40 empfangene Signal wird an einem Ende der Empfangsschleife 40 über einen Kondensator 43 abgegriffen, wobei dieser Kondensator 43 so eingestellt werden soll, daß eine Impedanzanpassung an die Zuleitung bzw. die Auswerteeinheit 21 erfolgt.

Mit der Erfindung soll die in Fig. 3 dargestellte Schaltung für jedes Segment einer Oberflächenspule 19 z.B. nach Fig. 2 mit geringem Aufwand realisiert werden können.

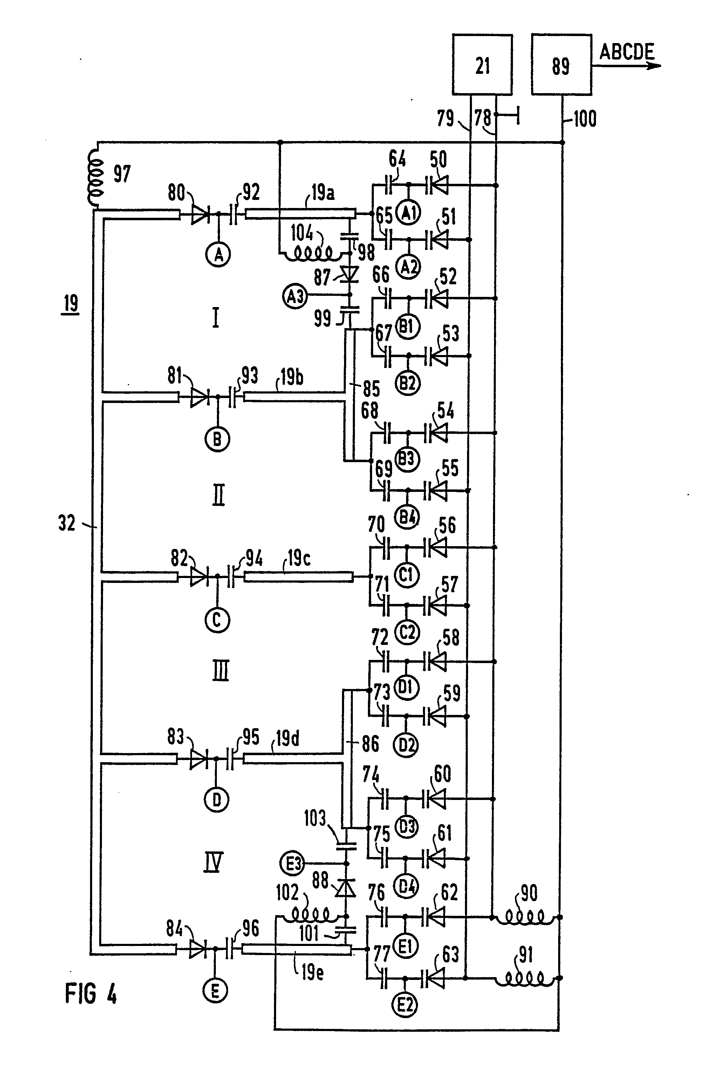

Ein Ausführungsbeispiel der Erfindung ist in Fig. 4 dargestellt. Auch hier besteht die Oberflächenspule 19 aus Außenleitern 32, 85, 86 und dazwischen angeordneten, in Abstand zueinander parallel liegenden Zwischenleitern 19a bis 19e. In Abweichung zum Beispiel nach Fig. 2 besteht hier der rechte Außenleiter aus zwei Stücken 85, 86, die fest mit den Zwischenleitern 19b bzw. 19d verbunden sind. Die Fig. 4 zeigt insofern nicht exakt die geometrische Anordnung, da tatsächlich die Enden des Außenleiterstückes 85 dicht an die Enden der Zwischenleiter 19a bzw. 19c und die Enden des Außenleiterstückes 86 dicht an die Enden der Zwischenleiter 19c bzw. 19e heranreichen.

Beim Ausführungsbeispiel nach Fig. 4 sind Enden der Zwischenleiter 19a, 19c und 19e jeweils über die Reihenschaltung eines Kondensators 64, 70 bzw. 76 und eines Varaktors 50, 56 bzw.62 als erste steuerbare Kapazität mit einer Signal-Bezugsleitung 78 sowie jeweils über die Reihenschaltung eines Kondensators 65, 71 bzw. 77 und eines Varaktors 51, 57 bzw.63 als zweiter steuerbarer Kapazität mit einer Signalleitung 79 verbunden. Ebenso sind die beiden Enden jedes Außenleiterstückes 85 und 86 jeweils über einen Kondensator 66, 68 bzw. 72, 74 und eine Varaktor-Diode 52, 54 bzw. 58, 60 mit der Signal-Bezugsleitung 78 und über die Reihenschaltung je eines Kondensators 67, 69 bzw. 73, 75 und einer Varaktor-Diode 53, 55 bzw. 59, 61 als zweiter steuerbarer Kapazität mit der Signalleitung 79 verbunden.

In jedem Zwischenleiter 19a bis 19e ist die Reihenschaltung einer PIN-Diode 80 bis 84 und eines Kondensators 92 bis 96 eingefügt. Das zweite Ende des Zwischenleiters 19a ist über die Reihenschaltung eines Kondensators 98, einer PIN-Diode 87 und eines weiteren Kondensators 99 mit dem benachbarten Ende des Außenleiterstückes 85 und das zweite Ende des Zwischenleiters 19e über die Reihenschaltung eines Kondensators 101, einer PIN-Diode 88 und eines weiteren Kondensators 103 mit dem benachbarten Ende des Außenleiterstückes 86 verbunden.

Alle Varaktor-Dioden 50 bis 63 und alle PIN-Dioden 80 bis 84 und 87, 88 werden von einer Steuereinrichtung 89 durch Anlegen einer Spannung an die Kathoden der entsprechenden Varaktor-bzw. PIN-Dioden angesteuert. Die entsprechenden Steueranschlüsse sind mit A... bis E... bezeichnet.

Die Bezugsleitung 100 der Steuereinrichtung 89 ist über eine Drossel 97 mit dem Außenleiter 32, eine Drossel 102 mit dem Verbindungspunkt zwischen Kondensator 101 und PIN-Diode 88, eine Drossel 104 mit dem Verbindungspunkt zwischen Kondensator 98 und PIN-Diode 87, eine Drossel 90 mit der Signal-Bezugsleitung 78 und eine Drossel 91 mit der Signalleitung 79 verbunden.

Mit der dargestellten Schaltung ist es möglich, wie bei der Schaltung nach Fig. 2 jedes der Segmente I bis IV einzeln oder zusammen zu aktivieren, d.h. an die Auswerteeinheit 21 anzuschließen. Die Aktivierung ist allein durch die Ansteuerung der PIN-Dioden 80 bis 83 und 87, 88 sowie der Varaktor-Dioden 50 bis 63 möglich. Dabei wird gleichzeitig die oben anhand von Fig. 3 erläuterte Resonanz- und Impedanzanpassung durchgeführt. Um beispielsweise das Segment I zu aktivieren, wird durch entsprechende Ansteuerung der Varaktor-Dioden 50 und 52 deren Kapazität so eingestellt, daß das Segment I resonant ist. Gleichzeitig werden die PIN-Dioden 80 und 81 in den leitenden Zustand gesteuert. Über die Varaktor-Diode 51 oder 53 wird das entstehende Signal der Auswerteschaltung 21 zugeführt, wobei durch entsprechende Steuerung der Varaktor-Diode 51 bzw. 53 eine Impedanzanpassung erfolgt. Die Kapazitäten aller übrigen Varaktor-Dioden 54 bis 63 werden so eingestellt, daß die verbleibenden Segmente II bis IV verstimmt sind. Ferner werden alle restlichen PIN-Dioden 82, 83, 84, 87 und 88 in den Sperrzustand geschaltet.

Für die Ansteuerung der Varaktor-Dioden sind somit nur drei Spannungen notwendig, nämlich eine für den Abgleich der entsprechenden Varaktor-Dioden auf die Resonanzbedingung, eine für den Abgleich der entsprechenden Varaktor-Dioden zur Impedanzanpassung und eine zum Steuern der Varaktor-Dioden zur Verstimmung. Diese drei Spannungen können in der Steuereinrichtung 89 z.B. durch Spannungsteiler vorgegeben und über Analogschalter an die jeweiligen Varaktor- bzw. PIN-Dioden geschaltet werden.

Über die Drossel 97 werden die PIN-Dioden 80 bis 84, über die Drossel 90 die Varaktor-Dioden 50, 52, 54, 56, 58, 60, 62, über die Drossel 91 die Varaktor-Dioden 51, 53, 55, 57, 59, 61, 63, über die Drossel 104 die PIN-Diode 87 und über die Drossel 102 die PIN-Diode 88 gleichspannungsmäßig mit der Bezugsleitung 100 der Steuerschaltung 89 verbunden. Die Drosseln verhindern dabei eine hochfrequenzmäßige Verkopplung. Durch den jeder PIN-Diode und jeder Varaktor-Diode zugeordneten Kondensator 92 bis 96, 64 bis 77 und 98, 99, 101, 103 wird erreicht, daß jedes Steuersignal, das in Form eines Gleichspannungssignals angelegt wird, nur auf die jeweils zugeordnete Diode wirkt.

Die Aktivierung der gesamten Oberflächenspule, d.h. der Segmente I bis IV, wird im folgenden als Sonderfall näher erläutert. Würde man hierbei einfach die beiden Zwischenleiter 19a und 19e über je eine Varaktor-Diode 50 bzw. 62 an die Signal-Bezugsleitung 78 legen, so würde die wirksame Empfangsschleife auch den zwischen den Varaktor-Dioden 50 und 62 liegenden Teil der Signal-Bezugsleitung 78 umfassen. Dies ist jedoch unerwünscht, da diese Signal-Bezugsleitung zweckmäßigerweise außer halb der Oberflächenspule 19 angeordnet wird. Wenn man daher die gesamte Oberflächenspule 19 aktivieren will, werden die PIN-Dioden 87 und 88 in den leitenden Zustand geschaltet und die Anordnung über die Varaktor-Dioden 54 und 58 auf Resonanz abgestimmt. Damit werden die Außenleiterstücke 85 und 86 Teil der Empfangsschleife. Da die einander zugewandten Enden der Außenleiterstücke 85 und 86 - wie bereits erwähnt - eng benachbart sind, erhält man eine über die Leiter der Oberflächenspule geschlossene Empfangsschleife.

In äquivalenter Weise wird die PIN-Diode 87 auch dann eingeschaltet, wenn das Segment I zusammen mit den Segmenten II oder III aktiviert wird und die PIN-Diode 88 wird dann eingeschaltet, wenn das Segment IV zusammen mit den Segmenten III oder II aktiviert wird.

Um zu verhindern, daß die zur Ansteuerung der PIN- und Varaktordioden notwendigen Steuerleitungen in unerwünschter Weise bei der Hochfrequenz-Einstrahlung als Antenne wirken und damit Hochfrequenzsignale aus dem Untersuchungsraum hinaus übertragen, kann man die Außen- und Innenleiter 32, 19a-19e, 85, 86 als Rohre ausführen und die Steuerleitungen in diesen Rohren unterbringen. Damit sind die Steuerleitungen abgeschirmt.

Zusammenfassend ist festzustellen, daß mit der dargestellten Oberflächenspule auf einfache Weise unterschiedliche Segmente aktiviert und dabei gleichzeitig auf Resonanz- und Impedanzanpassung abgestimmt werden können. Durch die Möglichkeit des schnellen Wechsels von einem Segment zum anderen kann die Umschaltung im Rahmen einer Schichtauswahl bei einer Pulssequenz zur schichtselektiven Anregung von Kernspins erfolgen. Damit kann man den gesamten, von der Oberflächenspule erfaßten Untersuchungsbereich schichtweise erfassen, ohne bei der Umschaltung von einem Segment zum anderen eine Unterbrechung der Pulssequenzen zur Anregung der Kernspins in Kauf nehmen zu müssen.

## Ansprüche

1. Oberflächenspule für ein Kernspin-Resonanzgerät zur Ermittlung von Spektren oder Bildern eines Untersuchungsobjektes, bestehend aus einer Leiteranordnung, die zu verschiedenen aktiven Spulensegmenten (I-IV) in Form von Empfangsschleifen unterschiedlicher Größe und/oder Lage zusammengeschaltet werden kann, **dadurch gekennzeichnet,** daß jedes Ende jeder möglichen Empfangsschleife (I bis IV) über eine erste steuerbare Kapazität (50, 52, 54, 56, 58, 60, 62) mit einer Signal-Bezugsleitung (78) und über eine zweite steuerbare Kapazität (51, 53, 55, 57, 59, 61, 63) mit einer an eine Auswerteeinheit (21) angeschlossenen Signalleitung (79) verbunden ist.

2. Oberflächenspule nach Anspruch 1, **dadurch gekennzeichnet,** daß jede einem nicht aktivierten Spulensegment (I bis IV) zugeordnete Empfangsschleife auftrennbar ist.

3. Oberflächenspule nach Anspruch 1, bestehend aus einer Anordnung von zwei Außenleitern (32, 85, 86) und mehreren räumlich getrennt angeordneten und mit den Außenleitern (32, 85, 86) selektiv verbindbaren Zwischenleitern (19a bis 19e), wobei diese Anordnung so an eine Auswerteeinheit (21) anschließbar ist, daß räumlich unterschiedliche Spulensegmente aus Außenleitern (32, 85, 86) und Zwischenleitern (19a bis 19e) aktivierbar sind, und wobei ein erster Anschluß jedes Zwischenleiters (19a bis 19e) mit einem ersten Außenleiter (32) verbunden ist, **dadurch gekennzeichnet.** daß ein zweiter Anschluß jedes Zwischenleiters (19a bis 19e) über je einen ersten steuerbaren Kondensator (50, 52, 54, 56, 58, 60, 62) mit der Signal-Bezugsleitung (78) und über je einen zweiten steuerbaren Kondensator (51, 53, 55, 57, 59, 61, 63) mit der Signalleitung (79) verbunden ist.

4. Oberflächenspule nach den Ansprüchen 2 und 3, **dadurch gekennzeichnet,** daß der erste Anschluß jedes Zwischenleiters (19a bis 19e) über je einen steuerbaren Schalter (80 bis 84) mit dem ersten Außenleiter (32) verbunden ist.

5. Oberflächenspule nach einem der Ansprüche 1 bis 4, **dadurch gekennzeichnet,** daß der zweite Anschluß jedes zweiten Zwischenleiters (19b, 19d) fest mit je einem Außenleiterstück (85, 86) als zweiter Außenleiter verbunden ist, das dicht bis an die zweiten Anschlüsse der beiden benachbarten Zwischenleiter (19a, 19c, 19e) heranreicht und bei jedem dieser zweiten Zwischenleiter anstelle der Verbindung des zweiten Anschlusses des Zwischenleiters (19a, 19c, 19e) mit den steuerbaren Kondensatoren (50 bis 63) die beiden Enden des Außenleiterstücks (85, 86) jeweils über einen ersten steuerbaren Kondensator (52, 54, 58, 60) mit der Signal-Bezugsleitung (78) und über einen zweiten steuerbaren Kondensator (53, 55, 59, 61) mit der Signalleitung (79) verbunden sind.

6. Oberflächenspule nach Anspruch 5, **dadurch gekennzeichnet,** daß die zweiten Anschlüsse der beiden äußersten Zwischenleiter (19a, 19e) zusätzlich über einen steuerbaren Schalter (87, 88) jeweils mit dem benachbarten Ende des Außenleiterstückes (85, 86) verbunden sind.

7. Oberflächenspule nach einem der Ansprüche 1 bis 6, **dadurch gekennzeichnet,** daß jeder steuerbare Kondensator (50 bis 63) ein Varaktor ist und daß zwischen dem zweiten Anschluß jedes Zwischenleiters (19a, 19c, 19e) bzw. den Enden der Außenleiterstücke (85, 86) und den damit verbundenen steuerbaren Kondensatoren (50 bis 63) je ein Kondensator (64 bis 77) eingefügt ist und daß die von einer Steuereinrichtung (89) gelieferten Steuerspannungen jeweils an den Verbindungspunkt zwischen steuerbarem Kondensator (50 bis 63) und Kondensator (64 bis 77) angelegt werden.

8. Oberflächenspule nach Anspruch 7, **dadurch gekennzeichnet,** daß der Bezugspunkt der Steuereinrichtung (89) über jeweils eine Drossel (90, 91) mit der Signal-Bezugsleitung (78) und der Signalleitung (79) verbunden ist.

9. Oberflächenspule nach einem der Ansprüche 4 bis 8, **dadurch gekennzeichnet,** daß jeder steuerbare Schalter (80 bis 84, 87, 88) eine PIN-Diode ist.

10. Oberflächenspule nach Anspruch 9, **dadurch gekennzeichnet,** daß der dem ersten Außenleiter (32) der Oberflächenspule abgewandte Anschluß jeder PIN-Diode (80 bis 84) über je einen Kondensator (92 bis 96) mit dem Zwischenleiter (19a bis 19e) verbunden ist und daß die von einer Steuereinrichtung (89) gelieferten Steuerspannungen jeweils an den Verbindungspunkt von PIN-Diode (80 bis 84) und Kondensator (92 bis 96) angelegt werden.

11. Oberflächenspule nach Anspruch 10, **dadurch gekennzeichnet,** daß der Bezugspunkt der Steuereinrichtung (89) über eine Drossel (97) mit dem ersten Außenleiter (32) verbunden ist.

12. Oberflächenspule nach Anspruch 6, **dadurch gekennzeichnet,** daß jeder steuerbare Schalter (87, 88) eine PIN-Diode ist, zu der beidseitig Kondensatoren (98, 99, 101, 103) in Reihe geschaltet sind, daß die Steuerspannungen jeweils an einen Verbindungspunkt zwischen PIN-Diode (87, 88) und Kondensator (99, 103) angelegt werden und daß jeweils der zweite Verbindungspunkt zwischen PIN-Diode (87, 88) und Kondensator (98, 101) über je eine Drossel (102, 104) mit dem Bezugspunkt der Steuereinrichtung (89) verbunden ist.

13. Oberflächenspule nach einem der Ansprüche 1 bis 12, **dadurch gekennzeichnet,** daß die Leiterabschnitte (32, 19a-19e, 85, 86) der Oberflächenspule als Rohre ausgeführt sind und daß die Steuerleitungen für die steuerbaren Kondensatoren (50-63) und die steuerbaren Schalter (80-84, 87, 88) in diesen Rohren geführt sind.

14. Verfahren zur Ansteuerung einer Oberflächenspule nach einem der Ansprüche 1 bis 13, **dadurch gekennzeichnet,** daß eine ein gewünschtes Segment (I bis IV) einschließende Empfangsschleife aktiviert wird, indem die steuerbaren Kondensatoren (50 bis 77) wie folgt angesteuert werden:

a) die Kondensatoren (50 bis 63), die die aktivierte Empfangsschleife (I bis IV) mit der Signal-Bezugsleitung verbinden, werden so abgestimmt, daß sich die gewünschte Empfangsschleife der Oberflächenspule in Resonanz befindet,

b) ein Kondensator (64 bis 77), der die aktivierte Empfangsschleife (I bis IV) mit der Signalleitung (79) verbindet, wird so abgestimmt, daß eine Impedanzanpassung zwischen der aktivierten Empfangsschleife (I-IV) der Oberflächenspule und der Signalleitung (79) erfolgt,

c) die übrigen Teile der Oberflächenspule werden verstimmt, indem die Kapazität der entsprechenden Kondensatoren auf ein Minimum eingestellt wird.

15. Verfahren zur Ansteuerung einer Oberflächenspule nach einem der Ansprüche 2 bis 13, **dadurch gekennzeichnet,** daß die den nicht aktivierten Empfangsschleifen (I bis IV) zugeordneten steuerbaren Schalter (80 bis 84) geöffnet werden.

FIG 1

FIG 2

FIG 3

FIG 4

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| Y | US-A-4 717 881 (D.C. FLUGAN)<br>* Spalte 3, Zeile 3 - Spalte 4, Zeile 55; Figuren 2,3,4A *<br>--- | 1,2 | G 01 R 33/36 |
| Y | SOCIETY OF MAGNETIC RESONANCE IN MEDICINE, Band 2, Seite 108, SEVENTH ANNUAL MEETING AND EXHIBITION, San Francisco, California, US, 20.-26. August 1988; H. KEREN et al.: "Dual frequency matched surface coil"<br>* Linke Spalte, Zeilen 7-19; Figur 1 *<br>--- | 1,2 | |
| A | EP-A-0 280 908 (SIEMENS AG)<br>* Spalte 3, Zeile 15 - Spalte 4, Zeile 50; Figuren 2,3 *<br>--- | 1-3 | |
| A | EP-A-0 175 129 (GENERAL ELECTRIC CO.)<br>* Seite 6, Zeile 15 - Seite 11, Zeile 33; Figur 3 *<br>--- | 1,2,7,9 | |
| A | US-A-4 825 162 (ROEMER et al.)<br>* Spalte 4, Zeile 20 - Spalte 5, Zeile 34; Figuren 4,4A *<br>--- | 1,2 | RECHERCHIERTE SACHGEBIETE (Int. Cl.5)<br><br>G 01 N<br>G 01 R |
| A | EP-A-0 276 509 (N.V. PHILIPS' GLOEILAMPENFABRIEKEN)<br>* Spalte 4, Zeile 43 - Spalte 5, Zeile 52; Figuren 3-5 *<br>--- | 3-5,7,9 ,12 | |
| E | EP-A-0 325 351 (THE REGENTS OF THE UNIVERSITY OF CALIFORNIA)<br>* Spalte 3, Zeilen 15-58; Spalte 6, Zeilen 10-42; Spalte 8, Zeile 2 - Spalte 9, Zeile 13; Figuren 2,4,5 *<br>----- | 1,2,7,9 | |

Der vorliegende Recherchenbericht wurde für alle Patentansprüche erstellt

| Recherchenort | Abschlußdatum der Recherche | Prüfer |
|---|---|---|
| DEN HAAG | 12-01-1990 | HORAK G.I. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument
.................................................................
& : Mitglied der gleichen Patentfamilie, übereinstimmendes Dokument

EPO FORM 1503 03.82 (P0403)